# EUROPEAN PATENT APPLICATION

(11) **EP 3 165 629 A1**
(43) Date of publication of application: **10.05.2017**
(21) Application number: 16196911.8
(22) Date of filing: 02.11.2016
(51) Int. Cl.: C23C 4/10, C23C 14/08, C23C 14/10, C23C 14/54, C23C 4/11, C23C 4/134

(54) **PLASMA SPRAY PHYSICAL VAPOR DEPOSITION DEPOSITED ENVIRONMENTAL BARRIER COATING**

(30) Priority: 06.11.2015 US 201562252121 P
(71) Applicant: Rolls-Royce Corporation, Indianapolis, Indiana 46225 (US)
(72) Inventor: Gold, Matthew, Carmel, Indiana 46033 (US); Lee, Kang, Zionsville, Indiana 46077 (US)
(74) Representative: Rolls-Royce plc

(57) **Abstract**

A technique may include controlling, by a computing device, a vacuum pump to evacuate a vacuum chamber to high vacuum. The technique also may include controlling, by the computing device, a coating material source to provide a coating material to a plasma spray device, the coating material having a first composition including a first amount of a metal oxide and a second amount of silica. The second amount of silica may be greater than an amount of silica in a metal silicate including the first amount of metal oxide. The technique further may include controlling, by the computing device, the plasma spray device to deposit an environmental barrier coating on a substrate in the vacuum chamber using plasma spray physical vapor deposition, wherein the coating comprises the metal silicate.

## Description

### TECHNICAL FIELD

The disclosure relates to techniques for forming environmental barrier coatings using plasma spray physical vapor deposition.

### BACKGROUND

Ceramic or ceramic matrix composite (CMC) materials may be useful in a variety of contexts where mechanical and thermal properties are important. For example, components of high temperature mechanical systems, such as gas turbine engines, may be made from ceramic or CMC materials. Ceramic or CMC materials may be resistant to high temperatures, but some ceramic or CMC materials may react with some elements and compounds present in the operating environment of high temperature mechanical systems, such as water vapor. Reaction with water vapor may result in the recession of the ceramic or CMC material. These reactions may damage the ceramic or CMC material and reduce mechanical properties of the ceramic or CMC material, which may reduce the useful lifetime of the component. Thus, in some examples, a ceramic or CMC material may be coated with an environmental barrier coating, which may reduce exposure of the substrate to elements and compounds present in the operating environment of high temperature mechanical systems.

### SUMMARY

In some examples, the disclosure described a system that includes a vacuum pump, a vacuum chamber, a plasma spray device, a coating material source, and a computing device. The computing device may be configured to control the vacuum pump to evacuate the vacuum chamber to high vacuum. The computing device also may be configured to control the coating material source to provide a coating material to the plasma spray device, the coating material having a first composition including a first amount of a metal oxide and a second amount of silica. The second amount of silica may be greater than an amount of silica in a metal silicate including the first amount of metal oxide. Further, the computing device may be configured to control the plasma spray device to deposit an environmental barrier coating on a substrate in the vacuum chamber using plasma spray physical vapor deposition, wherein the coating includes the metal silicate.

The metal oxide may comprise at least one of alumina, barium oxide, strontium oxide, or a rare earth oxide.

The metal oxide may comprise a rare earth oxide, and wherein the metal silicate may comprise at least one of a rare earth monosilicate or a rare earth disilicate.

The coating material may further comprise alumina, and wherein the environmental barrier coating may further comprise alumina.

The computing device may be configured to control the plasma spray device to deposit the environmental barrier coating with a substantially dense microstructure.

The computing device may be configured to control the plasma spray device to deposit the environmental barrier coating with a columnar microstructure.

The computing device may be configured to control the plasma spray device to deposit a first layer of the environmental barrier coating with a substantially dense microstructure and a second layer of the environmental barrier coating with a columnar microstructure.

The environmental barrier coating may be deposited on at least one surface of the substrate that is not in a line-of-sight relationship with the plasma spray device.

In some examples, the disclosure describes a method that includes controlling, by a computing device, a vacuum pump to evacuate a vacuum chamber to high vacuum. The method also may include controlling, by the computing device, a coating material source to provide a coating material to a plasma spray device, the coating material having a first composition including a first amount of a metal oxide and a second amount of silica. The second amount of silica may be greater than an amount of silica in a metal silicate including the first amount of metal oxide. Additionally, the method may include controlling, by the computing device, the plasma spray device to deposit an environmental barrier coating on a substrate in the vacuum chamber using plasma spray physical vapor deposition, wherein the coating includes the metal silicate.

The metal oxide may comprise at least one of alumina, barium oxide, strontium oxide, or a rare earth oxide.

The metal oxide may comprise a rare earth oxide, and wherein the metal silicate may comprise at least one of a rare earth monosilicate or a rare earth disilicate.

The coating material may further comprise alumina, and wherein the environmental barrier coating may further comprise alumina.

The computing device may be configured to control the plasma spray device to deposit the environmental barrier coating with a substantially dense microstructure.

The computing device may be configured to control the plasma spray device to deposit the environmental barrier coating with a columnar microstructure.

The computing device may be configured to control the plasma spray device to deposit a first layer of the environmental barrier coating with a substantially dense microstructure and a second layer of the environmental barrier coating with a columnar microstructure.

The environmental barrier coating may be deposited on at least one surface of the substrate that is not in a line-of-sight relationship with the plasma spray device.

In some examples, the disclosure describes a computer readable storage device including instructions that, when executed, cause a computing device to control a vacuum pump to evacuate a vacuum chamber to high vacuum. The computer readable storage device also may include instructions that, when executed, cause the computing device to control a coating material source to provide a coating material to a plasma spray device, the coating material having a first composition including a first amount of a metal oxide and a second amount of silica. The second amount of silica may be greater than an amount of silica in a metal silicate including the first amount of metal oxide. Further, the computer readable storage device may include instructions that, when executed, cause the computing device to control the plasma spray device to deposit an environmental barrier coating on a substrate in the vacuum chamber using plasma spray physical vapor deposition, wherein the coating includes the metal silicate.

The metal oxide may comprise a rare earth oxide, and wherein the metal silicate may comprise at least one of a rare earth monosilicate or a rare earth disilicate.

The instructions, when executed, may cause the computing device to control the plasma spray device to deposit the environmental barrier coating with a substantially dense microstructure.

The instructions, when executed, may cause the computing device to control the plasma spray device to deposit the environmental barrier coating with a columnar microstructure.

The instructions, when executed, may cause the computing device to control the plasma spray device to deposit a first layer of the environmental barrier coating with a substantially dense microstructure and a second layer of the environmental barrier coating with a columnar microstructure.

The instructions, when executed, may cause the computing device to control the plasma spray device to deposit the environmental barrier coating on at least one surface of the substrate that is not in a line-of-sight relationship with the plasma spray device.

The details of one or more examples are set forth in the accompanying drawings and the description below. Other features, objects, and advantages will be apparent from the description and drawings, and from the claims.

### BRIEF DESCRIPTION OF DRAWINGS

FIG. 1 is a conceptual and schematic diagram illustrating an example system for forming a coating that includes an environmental barrier coating including a metal silicate using plasma spray physical vapor deposition.
FIG. 2 is a conceptual block diagram illustrating an example article including a substrate and a coating that includes an environmental barrier coating including a first, substantially dense layer, and a second, columnar layer.
FIG. 3 is a flow diagram illustrating an example technique for forming a coating that includes an environmental barrier coating including a metal silicate using plasma spray physical vapor deposition.
FIG. 4 is a scatter diagram illustrating an example relationship between excess silica in a coating material and an amount of silicon in a resulting coating.
FIG. 5 is a cross-sectional picture of an example coating deposited using PS-PVD as described in this disclosure.
FIG. 6 is a cross-sectional picture of an example coating deposited using PS-PVD as described in this disclosure.
FIG. 7 is a cross-sectional picture of an example coating deposited using PS-PVD as described in this disclosure.

### DETAILED DESCRIPTION

The disclosure describes systems and techniques for forming an environmental barrier coating (EBC) including a metal silicate using plasma spray physical vapor deposition (PS PVD). In some examples, PS PVD may be used to deposit a coating material including silica and a rare earth oxide (RE₂O₃), where RE is Lu (lutetium), Yb (ytterbium), Tm (thulium), Er (erbium), Ho (holmium), Dy (dysprosium), Tb (terbium), Gd (gadolinium), Eu (europium), Sm (samarium), Pm (promethium), Nd (neodymium), Pr (praseodymium), Ce (cerium), La (lanthanum), Y (yttrium), or Sc (scandium). The silica and rare earth oxide react to form the rare earth silicate. Rare earth silicates include rare earth monosilicates (RE₂S₂O₅, where RE is a rare earth element) and rare earth disilicates (RE₂Si₂O₇, where RE is a rare earth element). Rare earth silicates have different physical and chemical properties than a mechanical mixture of rare earth oxide and silica.

Silica and rare earth oxides may have different physical or chemical properties that make simultaneous deposition difficult. For example, silica may have a higher vapor pressure than a rare earth oxide at a given temperature and pressure, which results in silica being more likely to be lost via volatilization during the processing, resulting in less silicon condensing on a surface of a substrate in the EBC. Thus, when PS PVD is used to deposit a rare earth silicate from a single material source, the resulting EBC may have a different composition than the material source composition.

If a material source includes a stoichiometric amount of rare earth oxide and silica to form a rare earth monosilicate, the silica deficit in the deposited coating may result in excess rare earth oxide, which may form a second phase in the EBC and provides different properties to the EBC than rare earth monosilicate. Similarly, if a material source includes a stoichiometric amount of rare earth oxide and silica to form a rare earth disilicate, the silica deficit in the coating may result in excess rare earth monosilicate forming in the EBC, which may form a second phase in the EBC, and provides different properties to the EBC than rare earth disilicate. For example, when a composition of an EBC deviates from an intended chemical composition, environmental and thermal forces may degrade the EBC more quickly than predicted based on the intended composition. In some cases, the failure of the EBC may lead to the failure of the component coated with the EBC due to damage of the underlying substrate. Hence, if a particular rare earth silicate is desired in the EBC, control of the amount of rare earth oxide and silica in the material source is important to achieve that type of rare earth silicate in the EBC. Similar effects may occur for other metal silicates.

Described herein are techniques for depositing EBCs including metal silicates. In some examples, the EBCs may include substantially stoichiometric ratio of silica to metal oxide. In this way, in some examples, the EBC may include substantially no (e.g., no or nearly no) free silica, or substantially no free metal oxide. The techniques may include depositing the EBC from a coating material including a predetermined amount of excess silica. The amount of excess silica may be selected based on experimental or theoretical relationships between the amount of silica in the coating material and the amount of silica (e.g., within the metal silicate) in the resulting EBC.

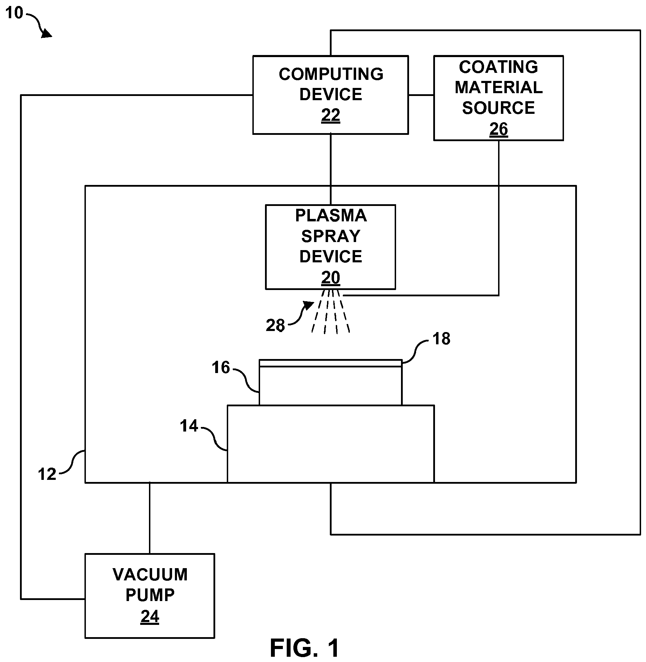

FIG. 1 is a conceptual and schematic diagram illustrating an example system 10 for forming a coating 18 including an EBC that includes a metal silicate using PS PVD. System 10 includes a vacuum chamber 12, which encloses a stage 14, and a plasma spray device 20. System 10 also includes a vacuum pump 24, a coating material source 26, and a computing device 22. A substrate 16 is disposed in enclosure 12 and includes coating 18.

Vacuum chamber 12 may substantially enclose (e.g., enclose or nearly enclose) stage 14, substrate 16, and plasma spray device 20. Vacuum chamber 12 is fluidically connected to at least one vacuum pump 24, which is operable to pump fluid (e.g., gases) from the interior of vacuum chamber 12 to establish a vacuum in vacuum chamber 12. In some examples, vacuum pump 24 may include multiple pumps or multiple stages of a pump, which together may evacuate vacuum chamber 12 to high vacuum. For example, vacuum pump 24 may include at least one of a scroll pump, a screw pump, a roots pump, a turbomolecular pump, or the like. As used herein, high vacuum may refer to pressures of less than about 10 torr (about 1.33 kilopascals (kPa)). In some examples, the pressure within vacuum chamber 12 during the PS-PVD technique may be between about 0.5 torr (about 66.7 pascals) and about 10 torr (about 1.33 kPa).

In some examples, during the evacuation process, vacuum chamber 12 may be backfilled with a substantially inert atmosphere (e.g., helium, argon, or the like), then the substantially inert gases removed during subsequent evacuation to the target pressure (e.g., high vacuum). In this way, the gas molecules remaining in vacuum chamber 12 under high vacuum may be substantially inert, e.g., to substrate 16 and coating 18.

In some examples, stage 14 may be configured to selectively position and restrain substrate 16 in place relative to stage 14 during formation of coating 18. In some examples, stage 14 is movable relative to plasma spray device 20. For example, stage 14 may be translatable and/or rotatable along at least one axis to position substrate 16 relative to plasma spray device 20. Similarly, in some examples, plasma spray device 20 may be movable relative to stage 14 to position plasma spray device 20 relative to substrate 16.

Plasma spray device 20 includes a device used to generate a plasma 28 for use in the PS PVD technique. For example, plasma spray device 20 may include a plasma spray gun including a cathode and an anode separated by a plasma gas channel. As the plasma gas flows through the plasma gas channel, a voltage may be applied between the cathode and anode to cause the plasma gas to form the plasma 28. In some examples, the coating material may be injected inside plasma spray device 20 such that the coating material flows through part of the plasma gas channel. In some examples, the coating material may be introduced to the plasma external to plasma spray device 20, as shown in FIG. 1. In some examples, the coating material may be a relatively fine powder (e.g., an average particle size of less than about 5 micrometers) to facilitate vaporization of the coating material by the plasma. In some examples, the relatively fine powder may be agglomerated into a composite powder that serves as the material fed to plasma spray device 20. The composite powder may have a particle size that is larger than the relatively fine powder.

Coating material source 26 may include at least one source of material which is injected into the plasma 28 generated by plasma spray device 20 and deposited in coating 18 on substrate 16. In some examples, the material may be in powder form, and may be supplied by coating material source 26 carried by a fluid, such as air, an inert gas, or the like.

In some examples, the coating includes an EBC including a metal silicate. The coating material may include particles of a metal monosilicate or a metal disilicate. In some examples, the coating material may include particles including a metal oxide, particles that include silica, or both, where the particles including metal oxide are separate from the particles including silica, and are mechanically mixed in a powder mixture. In other examples, the particles including metal oxide may be agglomerated with particles including silica to form larger particles. For example, particles of metal oxide and particles of silica may be mixed and agglomerated such that the agglomerated particles include a ratio of moles of metal oxide to moles of silica in an approximately stoichiometric amount for the selected type of silicate (e.g., a metal monosilicate or a metal disilicate).

In accordance with some examples of this disclosure, the coating material may include excess silica compared to the desired amount of silica in coating 18 (e.g., in the monosilicate or disilicate). In some examples, the excess silica may be mixed in the coating material as a separate powder. In other examples, the excess silica may be part of an agglomerate with the metal oxide.

The excess silica in the coating source may facilitate formation of an EBC with a desired composition. As described above, silica may have a higher vapor pressure than some other metal oxides, such as rare earth oxides, at a given pressure and temperature. This may result in silica being more likely to be lost via volatilization during the processing, such that silica deposits in coating 18 in a lower ratio than the ratio of silica in the coating material. Thus, by including excess silica in a predetermined amount, coating 18 may be formed with a desired amount of silica. For example, the excess amount of silica may be selected such that the ratio of silica to metal oxide deposited in coating 18 is substantially the same as a stoichiometric ratio of the desired metal silicate (e.g., a monosilicate or a disilicate). In other examples, the amount of silica in the coating material may be selected to result in a predetermined amount of excess silica or excess rare earth oxide in coating 18 compared to a stoichiometric ratio of metal oxide to silica in the desired metal silicate. This may result in a selected amount of free silica or free metal oxide in coating 18.

The amount of excess silica included in the coating material may depend on the desired composition of coating 18, and may be based on experimental testing. For example, a first coating material having a first ratio of silica to metal oxide may be formed and a coating deposited from the coating material using PS PVD. The composition of the resulting coating may be determined, and the ratio of silica to metal oxide (e.g., in the form of a metal silicate) in the coating may be compared to the ratio of silica to metal oxide in the coating material. This process may be repeated to determine an amount of excess silica to include in the coating material to form coating 18 with a desired composition.

In some examples, additional and optional constituents of coating 18 may be included in the coating material or another coating material used to deposit coating 18. For example, the additional and optional constituents may include alumina, an alkali metal oxide, an alkaline earth metal oxide, TiO₂, Ta₂O₅, HfSiO₄, or the like.

Computing device 22 may include, for example, a desktop computer, a laptop computer, a workstation, a server, a mainframe, a cloud computing system, or the like. Computing device 22 may include or may be one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor," as used herein may refer to any of the foregoing structure or any other structure suitable for implementation of the techniques described herein. In addition, in some examples, the functionality of computing device 22 may be provided within dedicated hardware and/or software modules.

Computing device 22 is configured to control operation of system 10, including, for example, stage 14, plasma spray device 20, and/or vacuum pump 24. Computing device 22 may be communicatively coupled to at least one of stage 14, plasma spray device 20, and/or vacuum pump 24 using respective communication connections. Such connections may be wireless and/or wired connections.

Computing device 22 may be configured to control operation of stage 14 and/or plasma spray device 20 to position substrate 16 relative to plasma spray device 20. For example, as described above, computing device 22 may control plasma spray device 20 to translate and/or rotate along at least one axis to position substrate 16 relative to plasma spray device 20.

As described above, system 10 may be configured to perform a PS PVD technique to deposit coating 18 on substrate 16. In some examples, substrate 16 may include component of a high temperature mechanical system, such as a gas turbine engine. For example, substrate 16 may be part of a seal segment, a blade track, an airfoil, a blade, a vane, a combustion chamber liner, or the like. In some examples, substrate may include a ceramic or a CMC. Example ceramic materials may include, for example, silicon carbide (SiC), silicon nitride (Si₃N₄), alumina (Al₂O₃), aluminosilicate, silica (SiO₂), transition metal carbides and silicides (e.g. WC, Mo₂C, TiC, MoSi₂, NbSi₂, TiSi₂),or the like. In some examples, substrate 16 additionally may include silicon metal, carbon, or the like. In some examples, substrate 16 may include mixtures of two or more of SiC, Si₃N₄, Al₂O₃, aluminosilicate, silica, silicon metal, carbon, or the like.

In examples in which substrate 16 includes a CMC, substrate 16 includes a matrix material and a reinforcement material. The matrix material includes a ceramic material, such as, for example, silicon metal, SiC, or other ceramics described herein. The CMC further includes a continuous or discontinuous reinforcement material. For example, the reinforcement material may include discontinuous whiskers, platelets, fibers, or particulates. As other examples, the reinforcement material may include a continuous monofilament or multifilament weave. In some examples, the reinforcement material may include SiC, C, other ceramic materials described herein, or the like. In some examples, substrate 16 includes a SiC-SiC ceramic matrix composite.

Coating 18 may include an environmental barrier coating (EBC) and, optionally, at least one other layer. For example, coating 18 may include a bond coat and an EBC. A bond coat may include, for example, silicon metal, alone, or mixed with at least one other constituent. For example, a bond coat may include silicon metal and at least one of a transition metal carbide, a transition metal boride, a transition metal nitride, mullite (aluminum silicate, Al₆Si₂O₁₃), silica, a silicide, an oxide (e.g., silicon oxide, a rare earth oxide, an alkali oxide, or the like), a silicate (e.g., a rare earth silicate or the like), or the like. In some examples, the additional constituent(s) may be substantially homogeneously mixed with silicon metal. In other examples, the additional constituent(s) may form a second phase distinct from the silicon metal phase.

Coating 18 also includes an EBC, alone or in addition to the bond coat. In examples in which coating 18 includes the EBC in addition to a bond coat, the EBC may be on the bond coat. The EBC may include constituents and a physical construction selected to reduce contact of underlying layers with chemical species present in the environment in which substrate 16 is used, such as water vapor, calcia-magnesia-alumina-silicate (CMAS; a contaminant that may be present in intake gases of gas turbine engines), or the like. The EBC may include at least one metal silicate, such as at least one rare earth silicate. For example, the EBC may include at least one metal monosilicate, such as at least one rare earth monosilicate (RE₂SiO₅, where RE is a rare earth element), at least one metal disilicate, such as at least one rare earth disilicate (RE₂Si₂O₇, where RE is a rare earth element), or combinations thereof. Rare earth elements include Lu, Yb, Tm, Er, Ho, Dy, Tb, Gd, Eu, Sm, Pm, Nd, Pr, Ce, La, Y, or Sc. As described above, rare earth silicates may be formed by reaction of silica and a rare earth oxide.

In some examples, the EBC additionally and optionally may include at least one additive, such as at least one of silica, a rare earth oxide, alumina, an aluminosilicate, an alkali metal oxide, an alkaline earth metal oxide, an alkali metal aluminosilicate, an alkaline earth aluminosilicate, TiO₂, Ta₂O₅, HfSiO₄, or the like. The additive may be added to the EBC to modify one or more desired properties of the EBC. For example, the additive components may increase or decrease the reaction rate of the EBC with calcia-magnesia-alumina-silicate (CMAS; a contaminant that may be present in intake gases of gas turbine engines), may modify the viscosity of the reaction product from the reaction of CMAS and constituent(s) of the EBC, may increase adhesion of the EBC to the bond coat, may increase the chemical stability of the EBC, or the like.

In some examples, the EBC may be a substantially non-porous layer (e.g., may include a porosity of less than about 5 volume percent). A substantially nonporous microstructure may substantially prevent (e.g., prevent or nearly prevent) environmental species such as water vapor, oxygen, molten salt, or calcia-magnesia-alumina-silicate (CMAS) deposits from contacting substrate 16 and degrading the material structure of substrate 16. For example, water vapor may react with a substrate 16 including a CMC and volatilize silica or alumina components in substrate 16. Consequently, an EBC which is substantially nonporous may provide protection to substrate 16 by preventing water vapor from contacting and reacting with substrate 16. In some examples, an EBC with a dense microstructure may have a porosity of less than about 10 vol. %, such as, e.g., less than about 5 vol. %, where porosity is measured as a percentage of pore volume divided by total EBC volume.

In some examples, the EBC may include a columnar microstructure. A columnar microstructure may have microcracks or microgaps that extend through at least a portion of the EBC in a direction that is substantially orthogonal to the plane defined by the EBC coating surface. Because of the microgaps, a columnar microstructure may have enhanced mechanical compliance under thermal cycling or when a temperature gradient exists, such as when a high-temperature system is first engaged. Additionally, an EBC having a columnar microstructure may provide improved thermal protection to substrate 16 compared to an EBC that is substantially nonporous. While not wishing to be bound by theory, the microcracks or microgaps may provide scattering sites for thermal energy-carrying phonons, which may lower an effective thermal conductivity of an EBC having a columnar microstructure compared to a substantially nonporous EBC of a similar composition.

In some examples, thermal protection and mechanical compliance are not the only benefits of a columnar microstructure EBC. An EBC having a columnar microstructure may also exhibit enhanced erosion resistance and enhanced sintering resistance relative to an EBC that does not include a columnar microstructure.

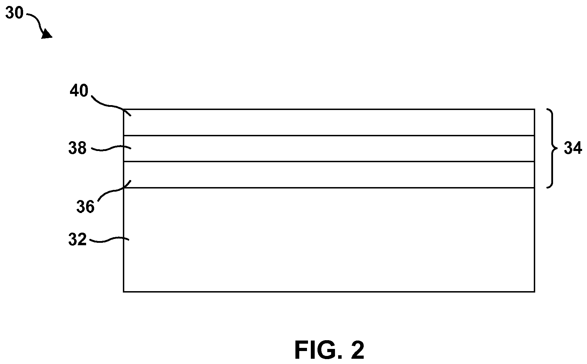

In some examples, coating 18 may include a first EBC layer and a second EBC layer, as shown in FIG. 2. FIG. 2 is a conceptual block diagram illustrating an example article 30 including a substrate 32 and a coating 34 that includes an environmental barrier coating including a first layer 38, and a second layer 40. Coating 34 also includes a bond coat 36, which, as described above, may be optional. In some examples, first EBC layer 38 and second EBC layer 40 may have different microstructures and/or different compositions, while in other examples, first EBC layer 38 and second EBC layer 40 may have similar microstructures and/or similar compositions. For example, the first EBC layer 38 may include a columnar microstructure and the second EBC layer 40 may include a substantially dense microstructure. Conversely, the first EBC layer 38 may include a substantially dense microstructure and the second EBC layer 40 may include a columnar microstructure.

With respect to the composition of first EBC layer 38 and second EBC layer 40, in some examples, first and second EBC layers 38, 40 may include the same constituents in similar proportions. In other examples, first and second EBC layers 38, 40 may include the same constituents in different proportions. For example, first EBC layer 38 may include a rare earth disilicate while second EBC layer 40 may include a rare earth monosilicate. The interface between first EBC layer 38 and second EBC layer 40 may be discrete, where there is a sharp compositional or microstructural transition between first EBC layer 38 and second EBC layer 40. Alternatively, the interface between first EBC layer 38 and second EBC layer 40 may be compositionally graded, where the interface transitions from being compositionally similar to first EBC layer 38 adjacent first EBC layer 38 to being compositionally similar to second EBC layer 40 adjacent to second EBC layer 40.

Computing device 22 may be configured to control operation of system 10 (e.g., vacuum pump 24, plasma spray device 20, and coating material source 26) to perform PS PVD to deposit the EBC. PS PVD may operate at low operating pressures, such as between about 0.5 torr and about 10 torr. In some examples, the temperatures of the plasma may be greater than about 6000 K, which may vaporize the coating material. Because the vaporized coating material is carried by a gas stream, PS PVD may allow deposition coating 18 on surfaces of substrate 16 that are not in line-of-sight relationship with plasma spray device 20, unlike thermal spray processes, such as air plasma spraying. Further, a deposition rate (e.g., thickness of coating deposited per unit time) may be greater for PS PVD than for other vapor phase deposition processes, such as chemical vapor deposition or physical vapor deposition, which may result in PS PVD being a more economical coating technique.

Moreover, PS PVD may be used to deposit coatings with different microstructural configurations, e.g., including a substantially dense microstructure, a columnar microstructure, or the like. For example, the rate at which coating material is fed by coating material source 26 into plasma 28 may affect the amount of the coating material that is vaporized by plasma 28. A higher rate of coating material being fed into plasma 28 may reduce the amount of the coating material that is vaporized by plasma 28. When substantially all of the coating material is vaporized, the resulting deposited EBC may be substantially nonporous, while when less coating material is vaporized, the resulting deposited EBC may have a columnar microstructure. In this way, a single coating technique, PS PVD may be used to deposit multiple layers of an EBC with different microstructures.

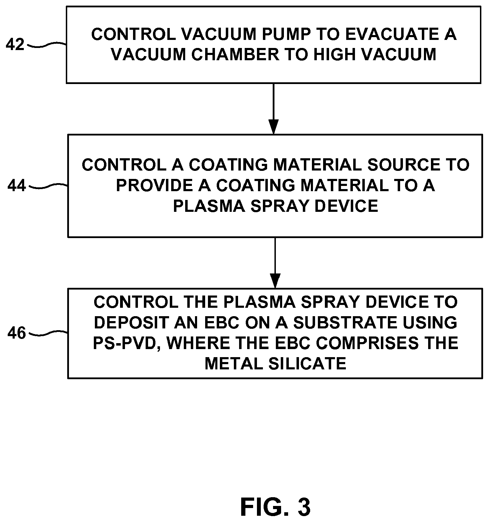

FIG. 3 is a flow diagram illustrating an example technique for forming a coating that includes an environmental barrier coating including a metal silicate using plasma spray physical vapor deposition. The technique of FIG. 3 will be described with respect to system 10 of FIG. 1 and article 30 of FIG. 2 for ease of description only. A person having ordinary skill in the art will recognize and appreciate that the technique of FIG. 3 may be implemented using systems other than system 10 of FIG. 1, may be used to form articles other than article 30 of FIG. 2, or both.

The technique of FIG. 3 may include, controlling, by computing device 22, vacuum pump 24 to evacuate vacuum chamber 12 to a high vacuum (42). As described above, vacuum pump 24 may be used to evacuate vacuum chamber 12 to high vacuum, e.g., less than about 10 torr (about 1.33 kPa), or between about 0.5 torr (about 66.7 pascals) and about 10 torr (about 1.33 kPa). In some examples, computing device 22 may control vacuum pump 24 and a source of substantially inert gas (e.g., helium, argon, or the like) to evacuate vacuum chamber 12 in multiple pump-downs. For example, computing device 22 may control vacuum pump 24 to evacuate vacuum chamber 12 of the atmosphere present when substrate 16 is placed in vacuum chamber 12. Computing device 22 then may control the source of the substantially inert gas to fill vacuum chamber 12 with the substantially inert gas. Computing device 22 may control vacuum pump 24 to evacuate vacuum chamber 12 of the substantially inert gas (and remaining atmosphere). In some examples, computing device 22 may control the source of the substantially inert gas and vacuum pump 24 to fill and evacuate vacuum chamber 12 at least one time (e.g., a plurality of times) to substantially remove reactive gases from vacuum chamber 12 and leave substantially only inert gases such as helium, argon, or the like in vacuum chamber 12.

The technique of FIG. 2 also may include, controlling, by computing device 22, coating material source 26 to provide a coating material to plasma spray device 20 (44). As described above, the coating material may include silica and at least one metal oxide, such as at least one rare earth oxide. The amount of the at least one metal oxide and the amount of silica may be selected so that coating 18 deposited from the coating material includes a predetermined ratio of the at least one metal oxide and silica. Due to the differences in vapor pressure between metal oxides and silica, the ratio of the at least one metal oxide and silica in the coating material provided by coating material source 26 may include additional silica compared to coating 18, as described above.

The excess silica in the coating source may facilitate formation of an EBC with a desired composition. As described above, silica may have a higher vapor pressure than some other metal oxides, such as rare earth oxides, at a given pressure and temperature. This may result in silica being more likely to be lost via volatilization during the processing, such that silica deposits in coating 18 in a lower ratio than the ratio of silica in the coating material. Thus, by including excess silica in a predetermined amount, coating 18 may be formed with a desired amount of silica. For example, the excess amount of silica may be selected such that the ratio of silica to metal oxide deposited in coating 18 is substantially the same as a stoichiometric ratio of the desired metal silicate (e.g., a monosilicate or a disilicate). In other examples, the amount of silica in the coating material may be selected to result in a predetermined amount of excess silica or excess rare earth oxide in coating 18 compared to a stoichiometric ratio of metal oxide to silica in the desired metal silicate. This may result in a selected amount of free silica or free metal oxide in coating 18.

The amount of excess silica included in the coating material may depend on the desired composition of coating 18, and may be based on experimental testing. For example, a first coating material having a first ratio of silica to metal oxide may be formed and a coating deposited from the coating material using PS PVD. The composition of the resulting coating may be determined, and the ratio of silica to metal oxide (e.g., in the form of a metal silicate) in the coating may be compared to the ratio of silica to metal oxide in the coating material. This process may be repeated to determine an amount of excess silica to include in the coating material to form coating 18 with a desired composition.

The technique of FIG. 3 also includes controlling, by computing device 22, plasma spray device 20 to deposit coating 18 including an EBC on substrate 16 (46). As described above, the EBC may include a metal silicate formed by reaction of the silica and the at least one metal oxide. During the PS PVD technique, the coating material may be introduced into plasma 28, e.g., internally or externally to plasma spray device 20. In PS PVD, vacuum chamber 12 is at a pressure lower than that used in low pressure plasma spray. For example, as described above, computing device 22 may control vacuum pump 24 to evacuate vacuum chamber 12 to a high vacuum with a pressure of less than about 10 torr (about 1.33 kPa). In contrast, in low pressure plasma spray, the pressure in a vacuum chamber is between about 50 torr (about 6.67 kPa) and about 200 torr (about 26.66 kPa). Because of the lower operating pressure, the plasma may be larger in both length and diameter, and may have a relatively uniform distribution of temperature and particle velocity.

The temperature of plasma 28 may, in some examples, be above about 6000 K, which may result in vaporization of substantially all (e.g., all or nearly all) of the coating material, depending upon the rate of introduction of the coating material to the plasma 28. Plasma 28 may carry the coating material toward substrate 16, where the coating material deposits in a layer on substrate 16. Because the coating material is carried by plasma 28 toward substrate 16, PS PVD may provide some non line-of-sight capability, depositing coating material on surfaces that are not in direct line of sight with plasma spray device 20. This may facilitate forming coating 18 on substrates with more complex geometry (e.g., non-planar geometry).

In some examples, during the PS-PVD technique, computing device 22 may control plasma spray device 20, stage 14, or both to move plasma spray device 20, substrate 16, or both relative to each other. For example, computing device 22 may be configured to control plasma spray device 20 to scan the plasma plume relative to substrate 16.

The techniques described in this disclosure may be implemented, at least in part, in hardware, software, firmware, or any combination thereof. For example, various aspects of the described techniques may be implemented within one or more processors, including one or more microprocessors, digital signal processors (DSPs), application specific integrated circuits (ASICs), field programmable gate arrays (FPGAs), or any other equivalent integrated or discrete logic circuitry, as well as any combinations of such components. The term "processor" or "processing circuitry" may generally refer to any of the foregoing logic circuitry, alone or in combination with other logic circuitry, or any other equivalent circuitry. A control unit including hardware may also perform one or more of the techniques of this disclosure.

Such hardware, software, and firmware may be implemented within the same device or within separate devices to support the various techniques described in this disclosure. In addition, any of the described units, modules or components may be implemented together or separately as discrete but interoperable logic devices. Depiction of different features as modules or units is intended to highlight different functional aspects and does not necessarily imply that such modules or units must be realized by separate hardware, firmware, or software components. Rather, functionality associated with one or more modules or units may be performed by separate hardware, firmware, or software components, or integrated within common or separate hardware, firmware, or software components.

The techniques described in this disclosure may also be embodied or encoded in a computer system-readable medium, such as a computer system-readable storage medium, containing instructions. Instructions embedded or encoded in a computer system-readable medium, including a computer system-readable storage medium, may cause one or more programmable processors, or other processors, to implement one or more of the techniques described herein, such as when instructions included or encoded in the computer system-readable medium are executed by the one or more processors. Computer system readable storage media may include random access memory (RAM), read only memory (ROM), programmable read only memory (PROM), erasable programmable read only memory (EPROM), electronically erasable programmable read only memory (EEPROM), flash memory, a hard disk, a compact disc ROM (CD-ROM), a floppy disk, a cassette, magnetic media, optical media, or other computer system readable media. In some examples, an article of manufacture may comprise one or more computer system-readable storage media.

### EXAMPLES

### Example 1

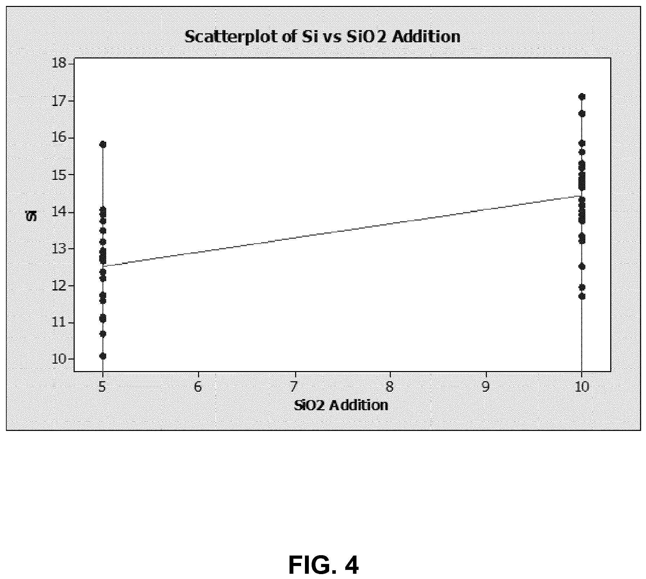

FIG. 4 is a scatter diagram illustrating an example relationship between excess silica in a coating material and an amount of silicon in a resulting coating. The units on the x-axis of FIG. 4 are weight percent excess silica (SiO₂) in the coating material. Excess silica is defined with reference to a stoichiometric amount of silica in the coating material. In this example, the coating material includes a mixture of silica, ytterbium disilicate (Yb₂Si₂O₇), and alumina. For the samples with 5 wt. % excess silica, the mixture included 1 wt. % alumina and a balance ytterbium disilicate. For the samples with 5 wt. % excess silica, the mixture included 3 wt. % alumina and a balance ytterbium disilicate. The units on the y-axis of FIG. 4 are weight percent elemental silicon (Si) in the resulting coating, as measured by a microprobe. A stoichiometric ytterbium disilicate would include about 10.9 wt. % silicon. As shown in FIG. 4, increasing excess silica in the coating material generally increased the amount of silicon in the resulting coating.

### Example 2

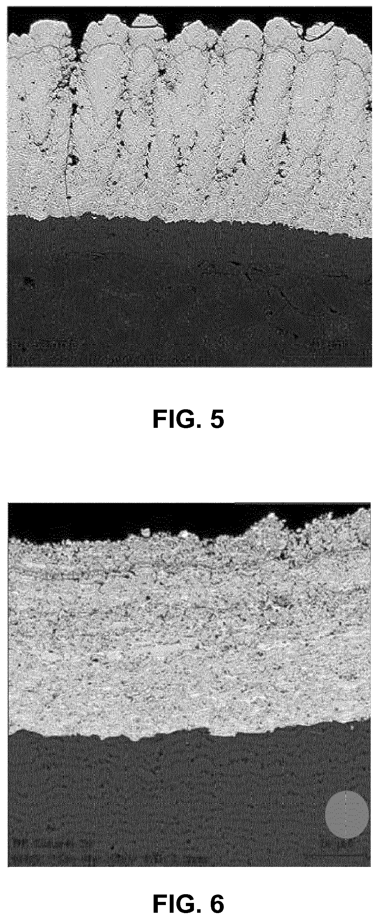

FIG. 5 is a cross-sectional picture of an example coating deposited using PS-PVD as described in this disclosure. The coating illustrated in FIG. 5 was deposited from a coating material including 5 wt. % excess silica, 1 wt. % alumina and a balance ytterbium disilicate. The PS-PVD parameters included using a He carrier gas with oxygen introduced into the PS-PVD chamber. The power was about 119.9 kW, and the coating time was about 12 minutes and 30 seconds. The coating was applied directly to the substrate with a line-of-sight relationship. As shown in FIG. 5, with these conditions, the coating included a columnar microstructure.

### Example 3

FIG. 6 is a cross-sectional picture of an example coating deposited using PS-PVD as described in this disclosure. The coating illustrated in FIG. 6 was deposited from a coating material including 5 wt. % excess silica, 3 wt. % alumina and a balance ytterbium disilicate. The PS-PVD parameters included using a carrier gas with oxygen introduced into the PS-PVD chamber. The power was about 116.6 kW, and the coating time was about 12 minutes. The coating was applied directly to the substrate with a line-of-sight relationship. As shown in FIG. 6, with these conditions, the coating included a porous microstructure, including closed pores that do not extend through the thickness of the coating.

### Example 4

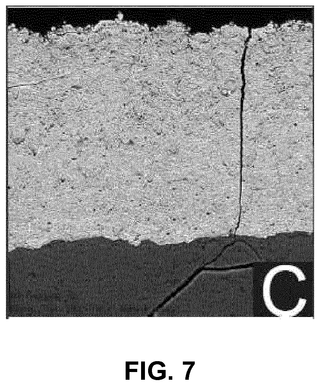

FIG. 7 is a cross-sectional picture of an example coating deposited using PS-PVD as described in this disclosure. The coating illustrated in FIG. 7 was deposited from a coating material including 5 wt. % excess silica, 3 wt. % alumina and a balance ytterbium disilicate. The PS-PVD parameters included using a He carrier gas with no oxygen introduced into the PS-PVD chamber. The power was about 117.0 kW, and the coating time was about 17 minutes and 30 seconds. The coating was applied directly to the substrate with a line-of sight relationship. As shown in FIG. 7, with these conditions, the coating included a substantially dense microstructure.

Various examples have been described. These and other examples are within the scope of the following claims.

## Claims

1. A system (10) comprising:
a vacuum pump (24);
a vacuum chamber (12);
a plasma spray device (20);
a coating material source (26); and
a computing device (22) operable to:
control the vacuum pump (24) to evacuate the vacuum chamber (12) to high vacuum;
control the coating material source (26) to provide a coating material to the plasma spray device (20), the coating material having a first composition including a first amount of a metal oxide and a second amount of silica, wherein the second amount of silica is greater than an amount of silica in a metal silicate including the first amount of metal oxide; and
control the plasma spray device (20) to deposit an environmental barrier coating on a substrate (16) in the vacuum chamber (12) using plasma spray physical vapor deposition, wherein the coating comprises the metal silicate.

2. The system of claim 1, wherein the metal oxide comprises at least one of alumina, barium oxide, strontium oxide, or a rare earth oxide.

3. The system of claim 1, wherein the metal oxide comprises a rare earth oxide, and wherein the metal silicate comprises at least one of a rare earth monosilicate or a rare earth disilicate.

4. The system of claim 3, wherein the coating material further comprises alumina, and wherein the environmental barrier coating further comprises alumina.

5. The system of any one of claims 1 to 4, wherein the computing device (22) is configured to control the plasma spray device (20) to deposit the environmental barrier coating with a substantially dense microstructure.

6. The system of any one of claims 1 to 4, wherein the computing device (22) is configured to control the plasma spray device (20) to deposit the environmental barrier coating with a columnar microstructure.

7. The system of any one of claims 1 to 4, wherein the computing device (22) is configured to control the plasma spray device (20) to deposit a first layer of the environmental barrier coating with a substantially dense microstructure and a second layer of the environmental barrier coating with a columnar microstructure.

8. The system of any one of claims 1 to 7, wherein the environmental barrier coating is deposited on at least one surface of the substrate (16) that is not in a line-of-sight relationship with the plasma spray device (20).

9. A method comprising:
controlling, by a computing device (22), a vacuum pump (24) to evacuate a vacuum chamber (12) to high vacuum;
controlling, by the computing device (22), a coating material source (26) to provide a coating material to a plasma spray device (20), the coating material having a first composition including a first amount of a metal oxide and a second amount of silica, wherein the second amount of silica is greater than an amount of silica in a metal silicate including the first amount of metal oxide; and
controlling, by the computing device (22), the plasma spray device (20) to deposit an environmental barrier coating on a substrate (16) in the vacuum chamber (12) using plasma spray physical vapor deposition, wherein the environmental barrier coating comprises the metal silicate.

10. The method of claim 9, wherein the metal oxide comprises at least one of alumina, barium oxide, strontium oxide, or a rare earth oxide.

11. The method of claim 9, wherein the metal oxide comprises a rare earth oxide, and wherein the metal silicate comprises at least one of a rare earth monosilicate or a rare earth disilicate.

12. The method of claim 11, wherein the coating material further comprises alumina, and wherein the environmental barrier coating further comprises alumina.

13. The method of any one of claims 9 to 12, wherein the computing device (22) is configured to control the plasma spray device (20) to deposit the environmental barrier coating with at least one of a substantially dense microstructure or a columnar microstructure.

14. The method of any one of claims 9 to 12, wherein the computing device (22) is configured to control the plasma spray device (20) to deposit a first layer of the environmental barrier coating with a substantially dense microstructure and a second layer of the environmental barrier coating with a columnar microstructure.

15. The method of any one of claims 9 to 12, wherein the environmental barrier coating is deposited on at least one surface of the substrate (16) that is not in a line-of-sight relationship with the plasma spray device (20).
